# EUROPEAN PATENT SPECIFICATION

(11) **EP 2 837 274 B1**
(45) Date of publication and mention of the grant of the patent: **07.06.2017**
(21) Application number: 13720252.9
(22) Date of filing: 02.04.2013
(51) Int. Cl.: H05K 7/20

(54) **HEAT DISSIPATION DEVICE FOR TELECOMMUNICATIONS EQUIPMENT**
WÄRMEABLEITUNGSVORRICHTUNG FÜR TELEKOMMUNIKATIONSVORRICHTUNGEN
DISPOSITIF DE DISSIPATION THERMIQUE DESTINÉ À UN ÉQUIPEMENT DE TÉLÉCOMMUNICATION

(30) Priority: 09.04.2012 US 201261621849 P; 08.03.2013 US 201313790654
(43) Date of publication of application: 18.02.2015
(73) Proprietor: CommScope Connectivity Belgium BVBA, 3010 Kessel-Lo (BE)
(72) Inventor: THIJS, Danny, Ghislain, B-3520 Zonhoven (BE); BLEUS, Heidi, B-3600 Genk (BE)
(74) Representative: Patentanwälte Bressel und Partner mbB
(86) International application number: PCT/EP2013/056894
(87) International publication number: WO 2013/152969

(56) References cited:
- EP-A2- 1 307 082
- FR-A1- 2 585 918
- US-A- 4 249 758
- US-B1- 6 375 561

## Description

### Field

The present disclosure relates generally to telecommunications equipment. More specifically, the present disclosure relates to an adjustable heat dissipation device that can be configured for use with different telecommunications equipment.

### Background

Heat dissipation is crucial when using high density telecommunications equipment such as high density electronic equipment. In high density environments such as cabinets or racks that house a large number of electronic devices in a stacked arrangement, the heat created by such equipment must be effectively exhausted.

For example, according to one example telecommunications environment, electronic devices such as electronic switching devices are designed and are also placed in cabinets so as to direct airflow from the fronts of the devices to the sides of the devices or from one side of each device to an opposite side of the device. In an environment where a cabinet housing a high density of switching devices is designed to have a cold temperature aisle in front of the cabinet and a high temperature aisle at the back of the cabinet, the hot air at the front of the cabinet needs to be redirected to the back side of the cabinet. If the switching devices are designed with exhaust ports at their sides, the heat built up at the sides of the switching devices needs to be directed to the back of the cabinet in order to prevent hot air from being pooled between two adjacent switching devices and from possibly being sucked into an inlet of an adjacent switching device.

As noted above, such switching devices may be designed with exhaust ports (e.g., positioned on their sides). However, depending upon the manufacturer or the type/model of device, the exact location and the dimension of the exhausts ports may vary. Any type of an exhausting arrangement that directs hot air from the exhaust ports of such switching devices to the back of the cabinet must be uniquely designed for each switching device from each manufacturer or for different types/models of devices.

An adjustable, more universal approach to heat dissipation is desired in such environments.

### Summary

The present disclosure relates to telecommunications equipment. The present disclosure relates to an adjustable heat dissipation device that can be configured for use with different types or models of telecommunications equipment or telecommunications equipment manufactured by different manufacturers, wherein such equipment may vary in the location and/or size of their heat exhaust ports or heat outlets.

According to one aspect, the heat dissipation device comprises a conduit defined by a flexible body, the conduit extending between an open first end and an open second end, wherein an outer dimension of at least one of the open first end and the open second end is adjustable in size.

According to another aspect, the present disclosure relates to a heat dissipation device for telecommunications equipment comprising an enclosed conduit extending between an open first end and an open second end, wherein the open first end is configured to be coupled to a heat outlet of a telecommunications fixture and the open second end is configured to be coupled to a heat outlet of a telecommunications device mounted within the telecommunications fixture so as to provide a heat transfer path between the heat outlets of the telecommunications device and the telecommunications fixture, wherein an outer dimension of the open second end is adjustable in size for corresponding to a variety of different sized heat outlets of different telecommunications devices that can be mounted within the telecommunications fixture, and wherein the enclosed conduit is defined by a flexible body for maintaining the heat transfer path between the heat outlet of the telecommunications fixture and a variety of different heat outlet locations of different telecommunications devices that can be mounted within the telecommunications fixture.

According to another aspect, the present disclosure relates to a method of accommodating heat dissipation from different telecommunications devices mounted within a telecommunications fixture, the method comprising providing a first conduit extending between an open first end and an open second end, coupling the open first end to a first heat outlet of the telecommunications fixture, and adjusting an outer dimension of the open second end in size and coupling the open second end to a heat outlet of a first telecommunications device mounted within the telecommunications fixture so as to provide a heat transfer path between the heat outlet of the first telecommunications device and the first heat outlet of the telecommunications fixture.

According to yet another aspect, the present disclosure relates to a telecommunications system comprising a telecommunications fixture including a heat outlet, a telecommunications device mounted within the telecommunications fixture, the telecommunications device including a heat outlet, and a heat dissipation device defining a conduit extending between an open first end and an open second end, wherein the open first end is coupled to the heat outlet of the telecommunications fixture and the open second end is coupled to the heat outlet of the telecommunications device so as to provide a heat transfer path between the heat outlets of the telecommunications device and the telecommunications fixture, wherein an outer dimension of the open second end is adjustable in size and the conduit is defined by a flexible body.

A variety of additional inventive aspects will be set forth in the description that follows. The inventive aspects can relate to individual features and combinations of features. It is to be understood that both the foregoing general description and the following detailed description are exemplary and explanatory only and are not restrictive of the broad inventive concepts upon which the embodiments disclosed herein are based.

### Brief Description of the Drawings

FIG. 1 is an example embodiment of a telecommunications system having inventive features in accordance with the present disclosure, the telecommunications system including a fixture, a telecommunications device mounted within the fixture, and a heat dissipation device extending between the telecommunications device and the fixture.
FIG. 2 is a top view of the telecommunications system of FIG. 1, diagrammatically illustrating typical hot and cold temperature zones surrounding the system;
FIG. 3 illustrates a portion of the telecommunications system of FIG. 1 from a front, top, left side perspective view;
FIG. 4 illustrates the telecommunications system of FIG. 3 from a rear, top, left side perspective view;
FIG. 5 illustrates the telecommunications system of FIGS. 3 and 4 from top view;
FIG. 6 illustrates a top view of another version of the telecommunications system of FIGS. 3 and 4, the heat dissipation device of the telecommunications system of FIG. 6 being attached to the telecommunications device via adhesive instead of suction;
FIG. 7 is a rear, top, left side perspective view of the heat dissipation device of FIGS. 1-5;
FIG. 8 is a rear, top, right side perspective view of the heat dissipation device of FIG. 7;
FIG. 9 is a right side view of the heat dissipation device of FIG. 7;
FIG. 10 is a bottom view of the heat dissipation device of FIG. 7;
FIG. 11 is a front view of the heat dissipation device of FIG. 7; and
FIG. 12 is a rear view of the heat dissipation device of FIG. 7.

### Detailed Description

Reference will now be made in detail to examples of inventive aspects of the present disclosure which are illustrated in the accompanying drawings. Wherever possible, the same reference numbers will be used throughout the drawings to refer to the same or like parts.

According to the present disclosure, an adjustable heat dissipation device that can be configured for use with different types or models of telecommunications equipment or telecommunications equipment manufactured by different manufacturers, wherein such equipment may vary in the location and size of their heat outlets or heat exhaust ports is described and illustrated.

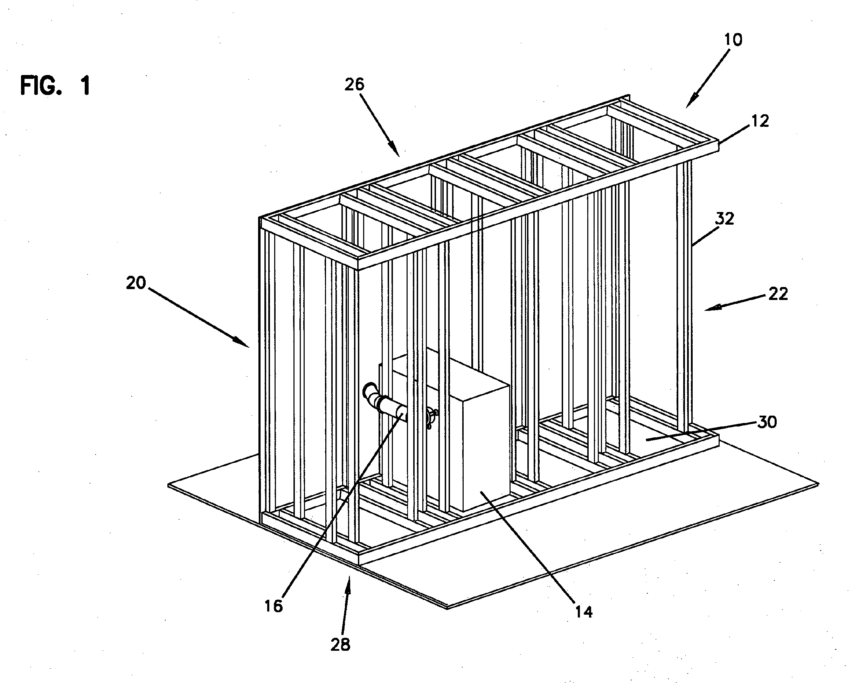

FIG. 1 illustrates a telecommunications system 10 that includes a telecommunications fixture 12, a telecommunications device 14 mounted within the telecommunications fixture 12, and a heat dissipation device 16 having inventive aspects in accordance with the present disclosure extending between the telecommunications device 14 and the telecommunications fixture 12. The telecommunications fixture 12 illustrated in FIG. 1 and the telecommunications device 14 mounted therein are used for describing and illustrating the inventive aspects of the heat dissipation device 16 of the present disclosure and it should be noted that the heat dissipation device 16 can be used in other types of telecommunications environments.

The telecommunications fixture 12 (e.g., a cabinet or a rack) illustrated in FIG. 1 defines front side 18, a rear side 20, a right side 22, a left side 24, a top side 26, and a bottom side 28. The telecommunications fixture 12 includes a number of discrete bays 30 for mounting telecommunications devices 14 in a stacked arrangement therein. According to one example embodiment, the telecommunications devices 14 mounted within the fixture may be electronic switching devices. When a number of telecommunications devices such as the device 14 shown in FIG. 1 are mounted in a high density, stacked arrangement, heat dissipation becomes crucial.

A telecommunications fixture such as the fixture 12 shown in FIG. 1 is designed with a generally open architecture formed by rails 32 to direct airflow through the fixture 12. And, telecommunications devices such as the electronic switching device 14 shown in FIG. 1 may be designed to direct airflow from the fronts 34 of the devices 14 to the sides 36 of the devices 14 or from one side of each device to an opposite side of the device 14. Thus, telecommunications devices such as the device 14 shown in FIG. 1 may include a heat outlet 38 at a side 36 of the device 14.

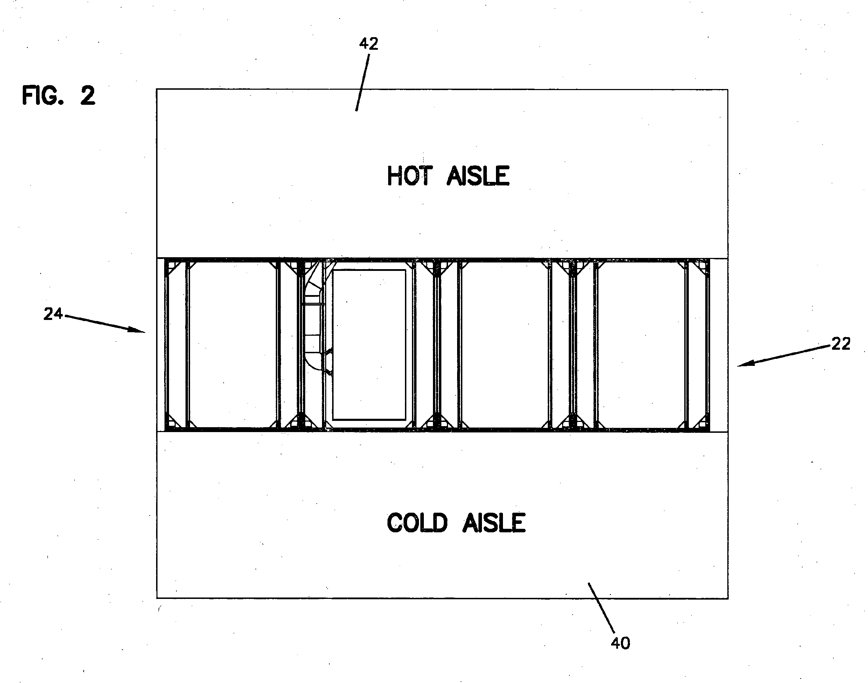

In an environment where a number of telecommunications fixtures such as the fixture 12 shown in FIG. 1 is located within a given space, each telecommunications fixture 12 housing a high density of telecommunications devices 14 may be designed to have a low temperature region 40 (i.e., aisle) at, for example, the front side 18 of the fixture 12 and a high temperature region 42 at, for example, the rear side 20 of the fixture 12. Please see FIG. 2. Thus, any high temperature air generated within the fixture 12 needs to be redirected to the rear side 20 of the fixture 12 and a fixture 12 may include a number of heat outlets 44 at, for example, a rear wall 46 thereof.

If the telecommunications devices 14 are designed with heat outlets or heat exhaust ports 38 at their sides 36, the heat built up at the sides 36 of the devices 14 needs to be directed to the heat outlets 44 at the rear wall 46 of the fixture 12 in order to prevent high temperature air from being pooled between two adjacent switching devices 14 within the fixture 12 and from possibly being sucked into an inlet of an adjacent switching device 14 that may be located near the heat outlet 44 of the first device 14.

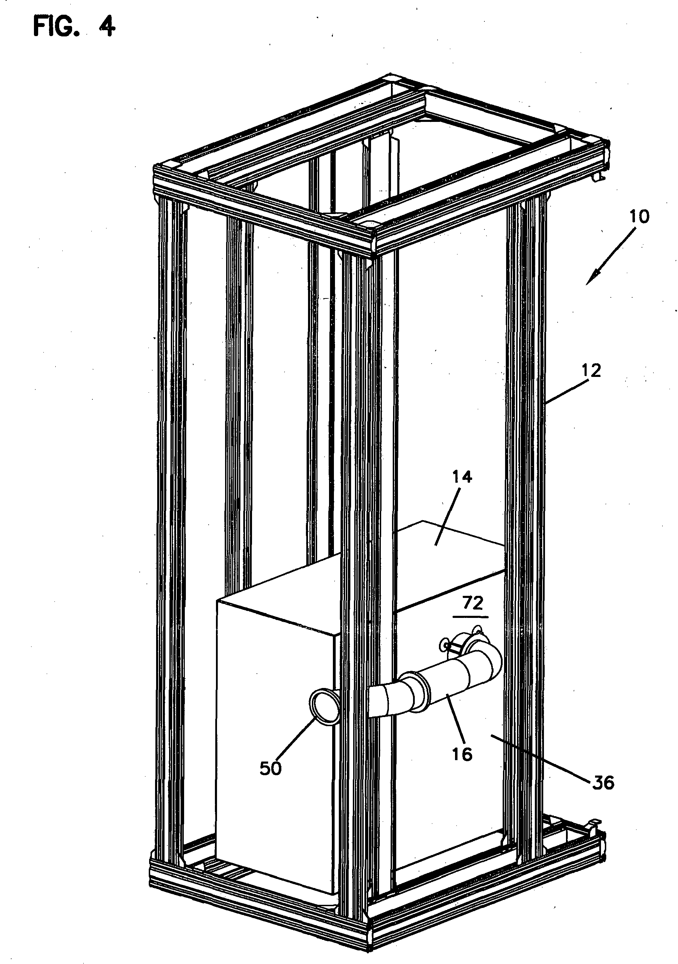

Depending upon the manufacturer or the type/model of telecommunications device 14, the exact location and the dimension of a heat outlet or exhaust port 38 may vary. The heat dissipation device 16 of the present disclosure, as will be discussed in further detail below, is configured to accommodate a variety of different sized heat outlets 38 of different telecommunications devices 14 that can be mounted within a fixture such as the telecommunications fixture 12 shown in FIGS. 1-4. The heat dissipation device 16 of the present disclosure also provides the flexibility to be able to maintain a heat transfer path between a heat outlet 44 of the telecommunications fixture 12 and a variety of different heat outlet locations of different telecommunications devices 14 that can be mounted within such a telecommunications fixture 12.

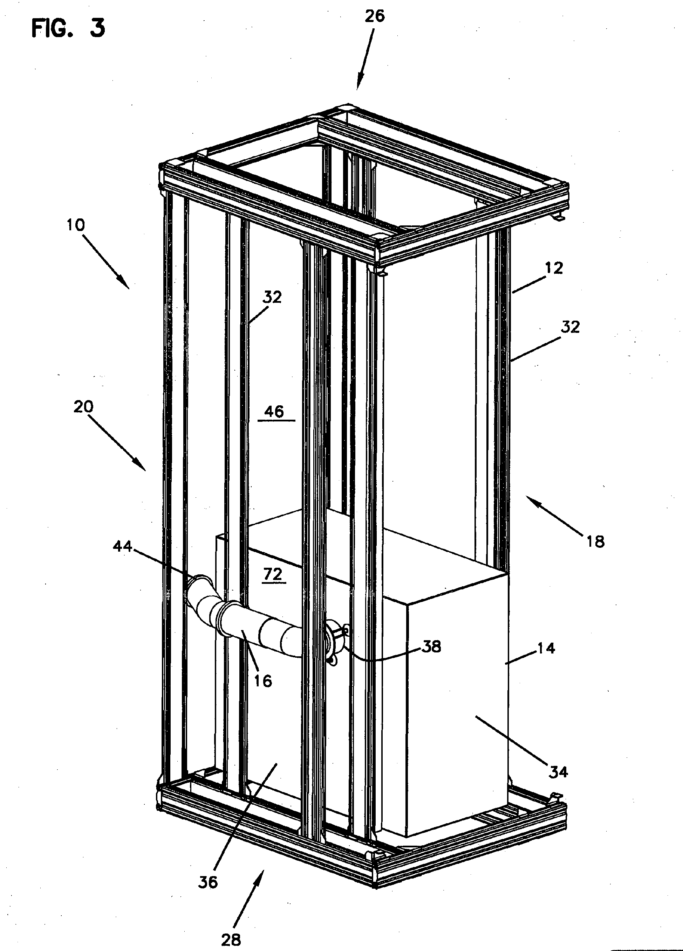

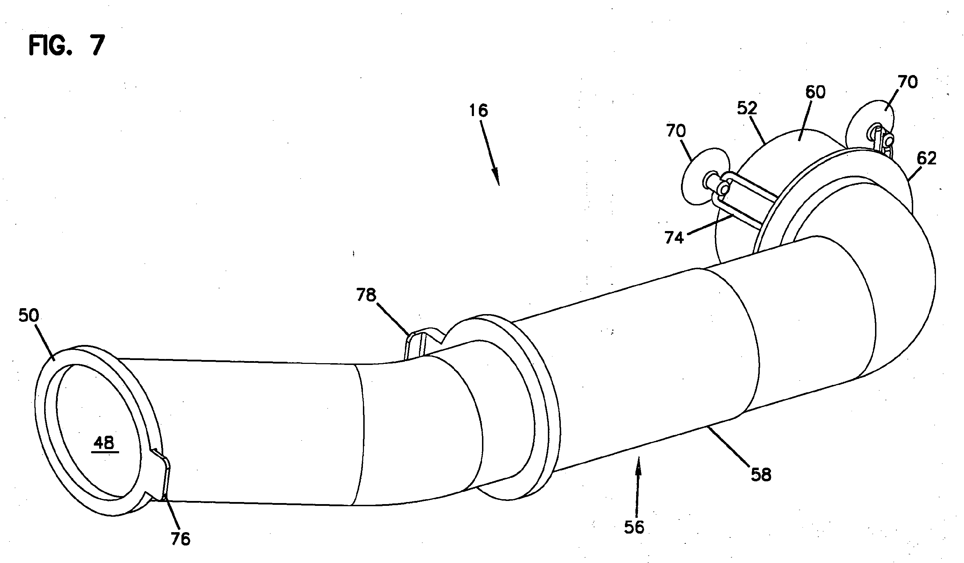

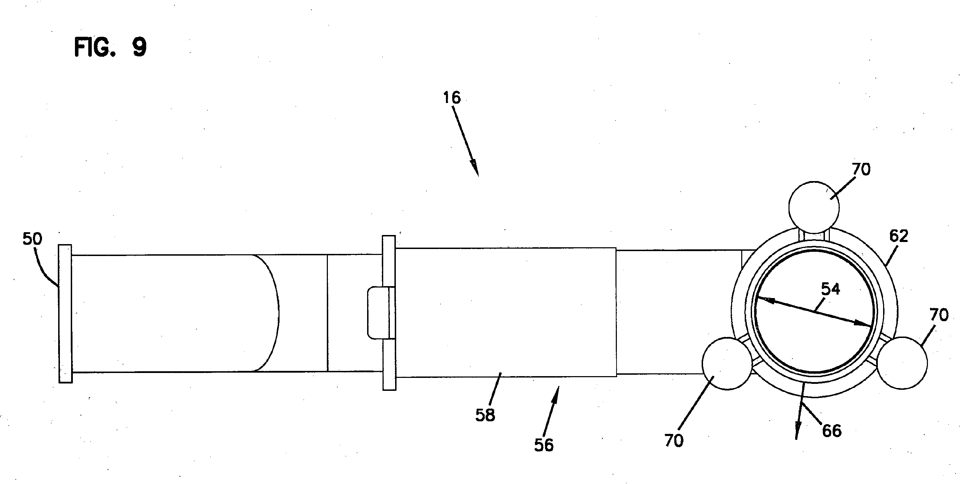

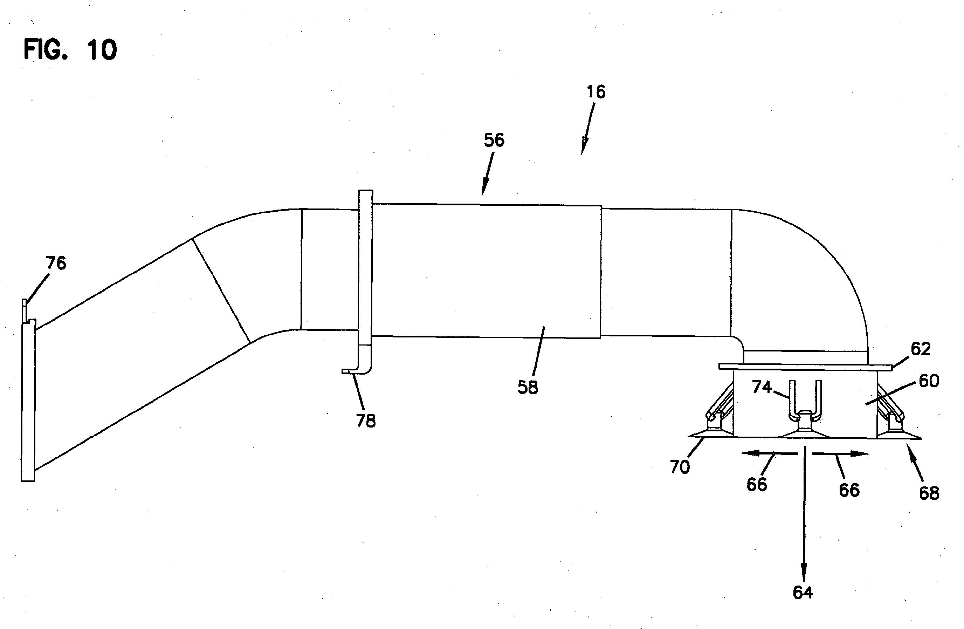

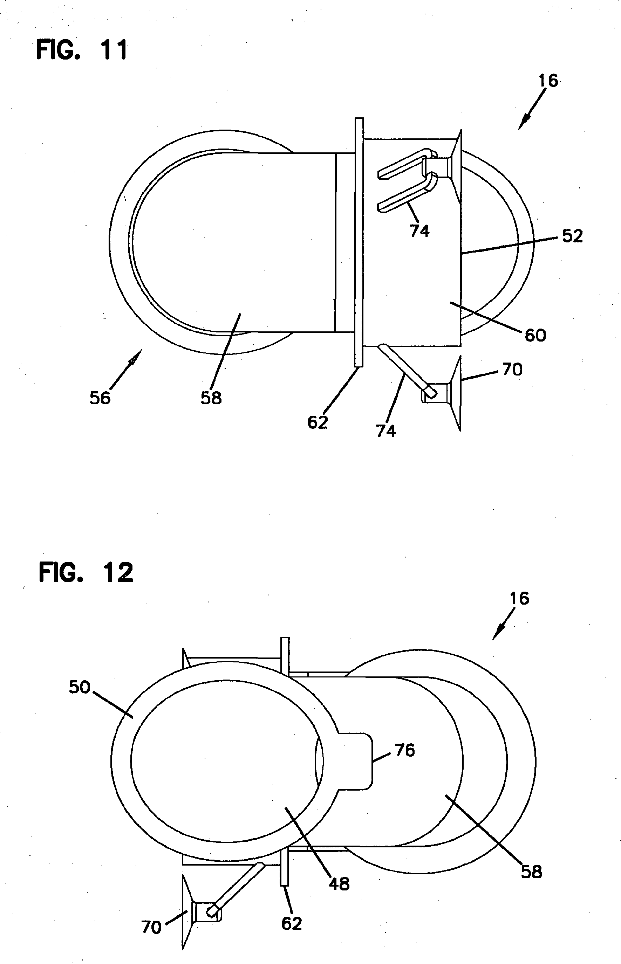

Referring now to FIGS. 3-5, a portion of the telecommunications fixture 12 is shown in close-up views to illustrate the heat dissipation device 16 of the present disclose in closer detail, mounted between the heat outlet 38 of the telecommunications device 14 and the heat outlet 44 of the fixture 12. And, in FIGS. 7-12, the heat dissipation device 16 is shown in isolation, removed from the telecommunications system 10 of FIGS. 1-5.

Referring to FIGS. 7-12, the heat dissipation device 16 defines a conduit 48 that extends between an open first end 50 and an open second end 52. The first end 50 is configured to be coupled to the heat outlet 44 of the telecommunications fixture 12. The second end 52 is configured to be coupled to the heat outlet 38 of a telecommunications device 14 mounted within the telecommunications fixture 12 such that the heat dissipation device 16 provides a heat transfer path between the heat outlets 38, 44 of the telecommunications device and the telecommunications fixture. As will be discussed in further detail below, an outer dimension 54 of the open second end 52 is adjustable in size for corresponding to a variety of different sized heat outlets 38 of different telecommunications devices 14 that can be mounted within the telecommunications fixture 12.

The conduit 48, in the depicted embodiment, is an enclosed conduit. In other embodiments, the conduit 48 may be only partially enclosed. The conduit 48 is defined by a body 56. The body 56 defining the conduit 48 is formed from a main body portion 58 coupled to a second end portion 60 by a ring structure 62. The ring structure 62 and the second end portion 60 that protrudes from the ring structure 62 are radially expandable so as to provide adjustability to the outer dimension 54 of the second end 52 of the heat dissipation device 16.

In the depicted embodiment, the main body portion 58 and the second end portion 60 of the heat dissipation device 16 are generally tubular. According to one embodiment, the tubular shape defines a generally cylindrical cross-section. It should be noted that the tubular shape may define other types of cross-sections such as square, rectangular, elliptical, etc.

When the second end portion 60 is of a generally cylindrical cross-section, the open second end 52 defines a cylinder and the outer dimension 54 corresponds to the diameter of that cylinder.

The conduit 48 of the heat dissipation device 16 defines a longitudinal axis 64 and the outer dimension 54 of the second end 52 is adjustable in a radial direction 66 with respect to the longitudinal axis 64.

According to one embodiment, the outer dimension 54 of the open second end 52 is adjustable in size between a first unadjusted dimension and a second adjusted dimension, wherein the second adjusted dimension is between about ,100% to 200%, of the first unadjusted dimension. According to another embodiment, the second adjusted dimension is between about 100% to 150% of the first unadjusted dimension.

It should be noted that although in the depicted embodiment, only the second end 52 is illustrated and described as being adjustable in size, in other embodiments, the first end 50 can also be adjustable in size to accommodate various telecommunications fixtures 12 or devices 14.

The second end portion 60 may be manufactured from different types of textiles.

Regarding the ring structure 62 that supports the expansion of the second end portion 60, certain portions of the ring 62 may be manufactured from different types of textiles that allow for those portions of the ring 62 to be expandable and certain portions that require a rigid platform could be manufactured from polymeric materials or different types of metallic materials such as f.i. metal.

Still referring to FIGS. 7-12, in addition to having a second end 52 that is adjustable in size for corresponding to a variety of different sized heat outlets 38 of different telecommunications devices 14 that can be mounted within the telecommunications fixture 12, the body 56 (or at least portions of the body 56 such as the main body portion 58) of the heat dissipation device 16 is constructed from a flexible material for adjustability in location between the heat outlet 44 of the telecommunications fixture 12 and the heat outlet 38 of the telecommunications device 14 mounted within the fixture 12. As such, the flexible body 56 defining the conduit 48 of the heat dissipation device 16 can maintain a heat transfer path between the heat outlet 44 of a given telecommunications fixture 12 and a variety of different heat outlet locations of different telecommunications devices 14 that can be mounted within the given telecommunications fixture 12.

Thus, referring to FIGS. 1-5, if the telecommunications device 14 shown therein was replaced by another device 14 and the heat outlet 38 of the second telecommunications device 14 was positioned at a location different than the location of the first one, the flexible body 56 of the heat dissipation device 16 would accommodate this change in location. Also, if different types of telecommunications devices 14 were mounted within the fixture 12, where the locations of the heat outlets 38 varied relative to their corresponding fixture heat outlets 44, the same type of heat dissipation device 16 could be used for all of the connections.

The flexible body 56 may be manufactured from different types of textiles, heat resistant rubber, ribbed aluminum or similar flexible materials. It should be noted that in certain embodiments, the flexible body 56 of the heat dissipation device 16 is constructed such that the overall outer dimension of the main body portion 58 remains generally the same while the length of the main body portion 58 may change (such as in an accordion-like structure).

Referring to FIGS. 1-12, the heat dissipation device 16 may include an attachment structure 68 adjacent the second end portion 60 of the body 56. According to one embodiment (shown in FIGS. 1-5 and 7-12), the attachment structure 68 is provided by suction cups 70 that are configured to provide a vacuum seal with a wall portion 72 of the telecommunications device 14 that surrounds the exhaust port 38. In the depicted embodiment, the suctions cups 70 are attached to the second end portion 60 of the body 56 via U-shaped links 74. In this manner, the suctions cups 70 radially surround the open second end 52 of the conduit 48 and are able to move radially outwardly with the expanding second end portion 60 of the body 56. Thus, the same attachment structure 68 of the heat dissipation device 16 is configurable and usable with different telecommunications devices 14. The suction cups 70 may be made from heat resistant materials to withstand the heat built up around the exhaust ports 38 of the telecommunications devices 14.

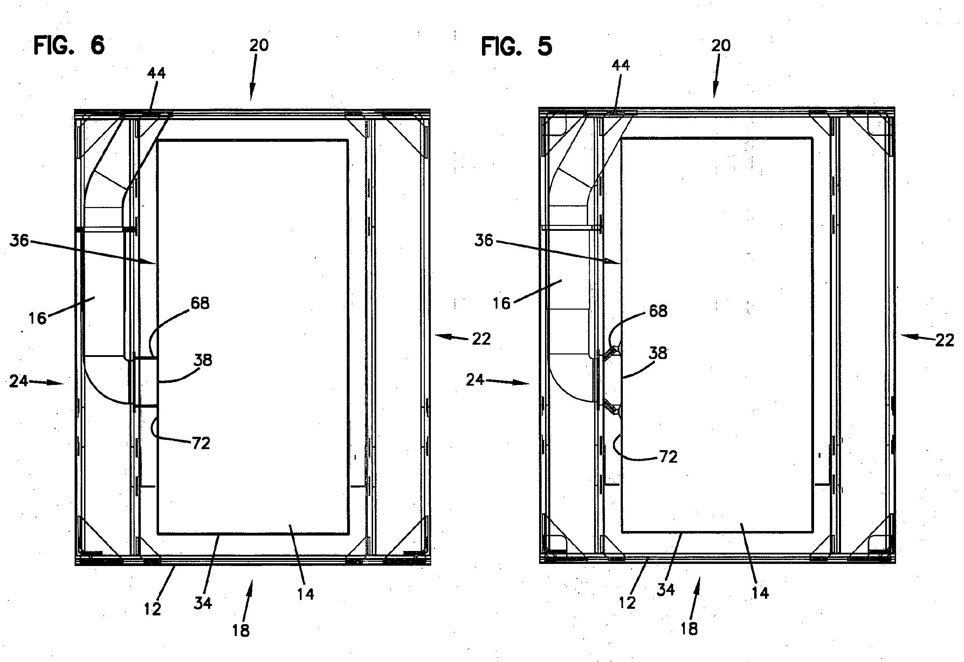

In other embodiments, other types of attachment structures 68 can be used. For example, according to one embodiment, removable adhesives can be used to attach the second end portion 60 of the body 56 to walls of the telecommunications devices 14. Such an embodiment is shown in FIG. 6.

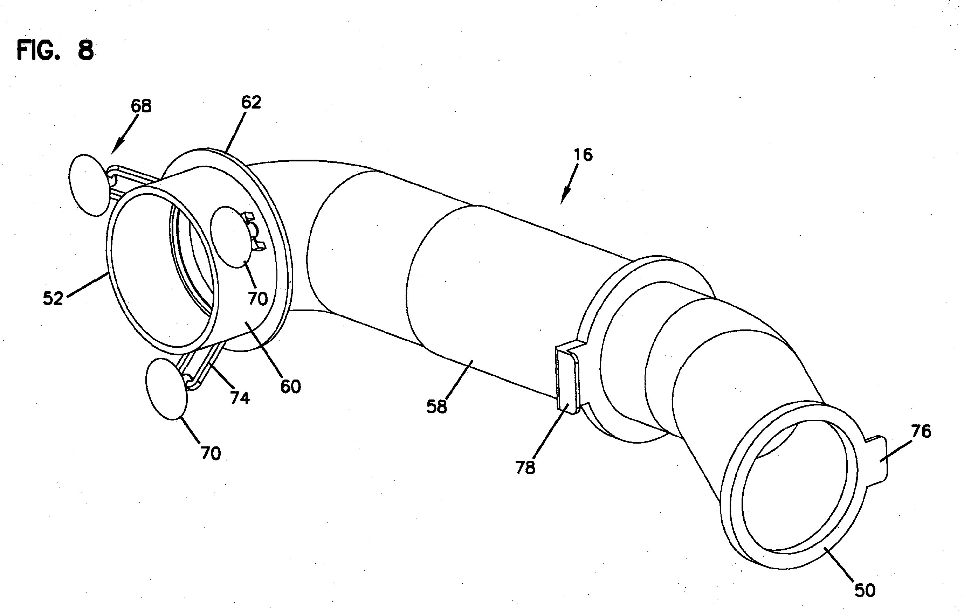

The first end 50 of the body 56 of the heat dissipation device 16 may be attached to the heat outlet 44 of the telecommunications fixture 12 by various means known in the art. One example attachment structure 76 is shown in FIGS. 7 and 8. If the heat outlet(s) 44 of the telecommunications fixture 12 is of a predetermined standard size (unlike those of the different types of telecommunications devices 14 that might be mounted therein), then the attachment structure 76 at the first end 50 does not have to provide for the adjustability provided by that of the one at the second end 52. As noted above, if desired, the first end 50 of the heat dissipation device 16 may also provide for the adjustability that is provided by the second end 52.

As shown in FIGS. 7-10, the body 56 of the heat dissipation device 16 may also include an additional attachment structure 78 at an intermediate location between the first and second ends 50, 52 for attaching to rails 32 of the telecommunications fixture 12.

Although in the foregoing description, terms such as "top", "bottom", "front", "back", "rear", "right", "left", "upper", and "lower" might have been used for ease of description and illustration, no restriction is intended by such use of the terms. The devices described herein can be used in any orientation, depending upon the desired application.

Having described the preferred aspects and embodiments of the present invention, modifications and equivalents of the disclosed concepts may readily occur to one skilled in the art. However, it is intended that such modifications and equivalents be included within the scope of the claims which are appended hereto.

### List of Reference Numerals and Corresponding Features

10 - Telecommunications system
12 - Telecommunications fixture
14 - Telecommunications device
16 - Heat dissipation device
18 - Front side of telecommunications fixture
20 - Rear side of telecommunications fixture
22 - Right side of telecommunications fixture
24 - Left side of telecommunications fixture
26 - Top side of telecommunications fixture
28 - Bottom side of telecommunications fixture
30 - Bays of telecommunications fixture
32 - Rails of telecommunications fixture
34 - Front of telecommunications device
36 - Side of telecommunications device
38 - Heat outlet/heat exhaust port of telecommunications device
40 - Low temperature region
42 - High temperature region
44 - Heat outlet of telecommunications fixture
46 - Rear wall of telecommunications fixture
48 - Conduit
50 - First end of heat dissipation device
52 - Second end of heat dissipation device
54 - Outer dimension of the second end
56 - Flexible body of the heat dissipation device
58 - Main body portion of the body
60 - Second end portion of the body
62 - Ring structure
64 - Longitudinal axis defined by conduit
66 - Radial direction
68 - Attachment structure at second end of heat dissipation device
70 - Suction cup
72 - Wall of telecommunications device
74 - U-shaped link
76 - Attachment structure at first end of heat dissipation device
78 - Attachment structure at intermediate location of heat dissipation device

## Claims

1. A heat dissipation device (16) for telecommunications equipment comprising:
a conduit (48) defined by a flexible body (56), the conduit (48) extending between an open first end (50) configured to be coupled to a heat outlet (44) of a telecommunications fixture (12) and an open second end (52) configured to be coupled to a heat outlet (38) of a tolecommunication device (14) mounted within the telecommunications fixture (12) so as to provide a heat transfer path between the heat outlet (38, 44), wherein the first conduit defines a longitudinal axis (64), wherein an outer dimension (54) of at least one of the open first end (50) and the open second end (52) is adjustable in size for corresponding to a variety of different sized heat outlets (38) of different telecommunications devices (14) that can be mounted within the telecommunications fixture (12) such that a portion of the conduit (48) defining at least one of the open first end (50) and the open second end (52) is made out of a material that is expandable in a radial direction (66) with respect to the longitudinal axis (64).

2. A heat dissipation device (16) according to claim 1, wherein the flexible body (56) is tubular.

3. A heat dissipation device (16) according to claim 2, wherein the tubular body (56) is generally cylindrical.

4. A heat dissipation device (16) according to claim 1, wherein the outer dimension (54) is a diameter of a circle defined by at least one of the open first end (50) and the open second end (52).

5. A heat dissipation device (16) according to claim 1, wherein the outer dimension (54) of only the second end (52) is adjustable in size.

6. A heat dissipation device (16) according to claim 1, wherein at least one of the open first end (50) and the open second end (52) includes an attachment structure (68) for coupling the at least one of the open first end (50) and the open second end (52) to a telecommunications device (14).

7. A heat dissipation device (16) according to claim 1, wherein the attachment structure (68) defines a suction cup (70) configured to provide a vacuum seal with the telecommunications device (14).

8. A heat dissipation device (16) according to claim 6, wherein the attachment structure (68) defines a plurality of suction cups (70) radially arranged around at least one of the open first end (50) and the open second end (52).

9. A heat dissipation device (16) according to claim 1, wherein the outer dimension (54) of at least one of the open first end (50) and the open second end (52) is adjustable in size between a first unadjusted dimension and a second adjusted dimension, wherein the second adjusted dimension is between about 100% to 200% of the first unadjusted dimension.

10. A heat dissipation device (16) according to claim 9, wherein the second adjusted dimension is between about 100% to 150% of the first unadjusted dimension.

11. A heat dissipation device (16) for telecommunications equipment comprising:
an enclosed conduit (48) extending between an open first end (50) and an open second end (52) and defining a longitudinal axis (64), wherein the open first end (50) is configured to be coupled to a heat outlet (44) of a telecommunications fixture (12) and the open second end (52) is configured to be coupled to a heat outlet (38) of a telecommunications device (14) mounted within the telecommunications fixture (12) so as to provide a heat transfer path between the heat outlets (38, 44) of the telecommunications device (14) and the telecommunications fixture (12), wherein an outer dimension (54) of the open second end (52) is adjustable in size for corresponding to a variety of different sized heat outlets (38) of different telecommunications devices (14) that can be mounted within the telecommunications fixture (12) such that a portion of the conduit (48) defining the open second end (52) is made out of a material that is expandable in a radial direction (66) with respect to the longitudinal axis (64), and wherein the enclosed conduit (48) is defined by a flexible body (56) for maintaining the heat transfer path between the heat outlet (44) of the telecommunications fixture (12) and a variety of different heat outlet (38) locations of different telecommunications devices (14) that can be mounted within the telecommunications fixture (12).

12. A heat dissipation device (16) according to claim 11, wherein the flexible body (56) is tubular.

13. A heat dissipation device (16) according to claim 12, wherein the tubular body (56) is generally cylindrical.

14. A heat dissipation device (16) according to claim 12, wherein the outer dimension (54) is a diameter of a circle defined by the open second end (52).

15. A heat dissipation device (16) according to claim 11, wherein the open second end (52) includes an attachment structure (68) that is configurable for coupling to different telecommunications devices (14).

16. A heat dissipation device (16) according to claim 15, wherein the attachment structure (68) defines a suction cup (70) configured to provide a vacuum seal attachment with different telecommunications devices (14).

17. A heat dissipation device (16) according to claim 16, wherein the attachment structure (68) defines a plurality of suction cups (70) radially arranged around the open second end (52).

18. A heat dissipation device (16) according to claim 11, wherein the outer dimension (54) of the open second end (52) is adjustable in size between a first unadjusted dimension and a second adjusted dimension, wherein the second adjusted dimension is between about 100% to 200% of the first unadjusted dimension.

19. A heat dissipation device (16) according to claim 18, wherein the second adjusted dimension is between about 100% to 150% of the first unadjusted dimension.

20. A method of accommodating heat dissipation from different telecommunications devices (14) mounted within a telecommunications fixture (12), the method comprising:
- providing a first conduit (48) extending between an open first end (50) and an open second end (52), wherein the first conduit (48) defines a longitudinal axis (64);
- coupling the open first end (50) to a first heat outlet (44) of the telecommunications fixture (12); and
- adjusting an outer dimension (54) of the open second end (52) in size for corresponding to a variety of different sized heat outlets (38) of different telecommunications devices (14) by expanding or contracting a portion of the first conduit (48) in a radial direction (66) with respect to the longitudinal axis (64), wherein the portion of the first conduit (48) defining the open second end (52) is made out of a material that is expandable in the radial direction (66) with respect to the longitudinal axis (64) and coupling the open second end (52) to a heat outlet (38) of a first telecommunications device (14) mounted within the telecommunications fixture (12) so as to provide a heat transfer path between the heat outlet (38) of the first telecommunications device (14) and the first heat outlet (44) of the telecommunications fixture (12).

21. A method according to claim 20, wherein the outer dimension (54) of the open second end (52) is adjustable in size for corresponding to a variety of different sized heat outlets (38) of different telecommunications devices (14) that can be mounted within the telecommunications fixture (12), and wherein the first conduit (48) is defined by a flexible body (56) for maintaining the heat transfer path between the first heat outlet (44) of the telecommunications fixture (12) and a variety of different heat outlet (38) locations of different telecommunications devices (14) that can be mounted within the telecommunications fixture (12).

22. A method according to claim 20, further comprising adjusting the outer dimension (54) of the open second end (52) in size from a first unadjusted dimension to a second adjusted dimension, wherein the second adjusted dimension is between about 100% to 200% of the first unadjusted dimension.

23. A method according to claim 22, wherein the second adjusted dimension is between about 100% to 150% of the first unadjusted dimension.

24. A method according to claim 20, further comprising providing a second conduit (48) similar to the first conduit (48) and coupling an open first end (50) of the second conduit (48) to a second heat outlet (44) of the telecommunications fixture (12) and adjusting an outer dimension (54) of an open second end (52) of the second conduit (48) in size and coupling the open second end (52) of the second conduit (48) to a heat outlet (38) of a second telecommunications device (14) mounted within the telecommunications fixture (12) so as to provide a heat transfer path between the heat outlet (38) of the second telecommunications device (14) and the second heat outlet (44) of the telecommunications fixture (12), wherein the second telecommunications device (14) includes a different sized heat outlet (38) than the first telecommunications device (14) that is mounted within the telecommunications fixture (12).

25. A method according to claim 24, wherein the second telecommunications device (14) defines a different heat outlet (38) location relative to the rest of the second telecommunications device (14) than the first telecommunications device (14).

26. A method according to claim 20, further comprising coupling the open second end (52) of the first conduit (48) to the heat outlet (38) of the first telecommunications device (14) via suction.

27. A method according to claim 20, further comprising coupling the open second end (52) of the first conduit (48) to the heat outlet (38) of the first telecommunications device (14) via adhesive.

28. A telecommunications system (10) comprising:
a telecommunications fixture (12) including a heat outlet (44);
a telecommunications device (14) mounted within the telecommunications fixture (12), the telecommunications device (14) including a heat outlet (38); and
a heat dissipation device (16) defining a conduit (48) extending between an open first end (50) and an open second end (52) and defining a longitudinal axis (64), wherein the open first end (50) is coupled to the heat outlet (44) of the telecommunications fixture (12) and the open second end (52) is coupled to the heat outlet (38) of the telecommunications device (14) so as to provide a heat transfer path between the heat outlets (38, 44) of the telecommunications device (14) and the telecommunications fixture (12), wherein an outer dimension (54) of the open second end (52) is adjustable in size for corresponding to a variety of different sized heat outlets (38) of different telecommunications devices (14) that can be mounted within the telecommunications fixture (12) such that a portion of the conduit (48) defining the open second end (52) is made out of a material that is expandable in a radial direction (66) with respect to the longitudinal axis (64) and the conduit (48) is defined by a flexible body (56).

29. A telecommunications system (10) according to claim 28, wherein the open second end (52) is coupled to the heat outlet (38) of the telecommunications device (14) with a suction cup (70).

30. A telecommunications system (10) according to claim 29, wherein the heat dissipation device (16) includes a plurality of the suction cups (70) radially arranged around the open second end (52) for coupling with the telecommunications device (14).

## Patentansprüche

1. Wärmeableitungsvorrichtung (16) für Telekommunikationsvorrichtungen, umfassend:
eine Leitung (48), die durch einen flexiblen Körper (56) definiert ist, wobei sich die Leitung (48) zwischen einem offenen ersten Ende (50), das dafür ausgelegt ist, mit einem Wärmeauslass (44) einer Aufnahmevorrichtung für Telekommunikationsausrüstung (12) gekoppelt zu werden, und einem offenen zweiten Ende (52), das dafür ausgelegt ist, mit einem Wärmeauslass (38) einer innerhalb der Aufnahmevorrichtung für Telekommunikationsausrüstung (12) angebrachten Telekommunikationsvorrichtung (14) gekoppelt zu werden, erstreckt, um einen Wärmeübertragungsweg zwischen den Wärmeauslässen (38, 44) bereitzustellen, wobei die erste Leitung eine Längsachse (64) definiert, wobei eine äußere Abmessung (54) des offenen ersten Endes (50) und/oder des offenen zweiten Endes (52) in der Größe verstellbar ist, um einer Vielzahl von Wärmeauslässen (38) unterschiedlicher Größe verschiedener Telekommunikationsvorrichtungen (14), welche innerhalb der Aufnahmevorrichtung für Telekommunikationsausrüstung (12) angebracht werden können, zu entsprechen, derart, dass ein Abschnitt der Leitung (48), der das offene erste Ende (50) und/oder das offene zweite Ende (52) definiert, aus einem Material hergestellt ist, welches in einer radialen Richtung (66) bezüglich der Längsachse (64) dehnbar ist.

2. Wärmeableitungsvorrichtung (16) nach Anspruch 1, wobei der flexible Körper (56) rohrförmig ist.

3. Wärmeableitungsvorrichtung (16) nach Anspruch 2, wobei der rohrförmige Körper (56) im Wesentlichen zylindrisch ist.

4. Wärmeableitungsvorrichtung (16) nach Anspruch 1, wobei die äußere Abmessung (54) ein Durchmesser eines Kreises ist, der durch das offene erste Ende (50) und/oder das offene zweite Ende (52) definiert ist.

5. Wärmeableitungsvorrichtung (16) nach Anspruch 1, wobei die äußere Abmessung (54) nur des zweiten Endes (52) in der Größe verstellbar ist.

6. Wärmeableitungsvorrichtung (16) nach Anspruch 1, wobei das offene erste Ende (50) und/oder das offene zweite Ende (52) eine Befestigungsstruktur (68) zum Koppeln dieses offenen ersten Endes (50) und/oder offenen zweiten Endes (52) mit einer Telekommunikationsvorrichtung (14) aufweist.

7. Wärmeableitungsvorrichtung (16) nach Anspruch 1, wobei die Befestigungsstruktur (68) einen Saugnapf (70) definiert, der dafür ausgelegt ist, eine Vakuumdichtung mit der Telekommunikationsvorrichtung (14) bereitzustellen.

8. Wärmeableitungsvorrichtung (16) nach Anspruch 6, wobei die Befestigungsstruktur (68) mehrere Saugnäpfe (70) definiert, die radial um das offene erste Ende (50) und/oder das offene zweite Ende (52) herum angeordnet sind.

9. Wärmeableitungsvorrichtung (16) nach Anspruch 1, wobei die äußere Abmessung (54) des offenen ersten Endes (50) und/oder des offenen zweiten Endes (52) in der Größe zwischen einer ersten, nicht verstellten Abmessung und einer zweiten, verstellten Abmessung verstellbar ist, wobei die zweite, verstellte Abmessung zwischen etwa 100 % und 200 % der ersten, nicht verstellten Abmessung liegt.

10. Wärmeableitungsvorrichtung (16) nach Anspruch 9, wobei die zweite, verstellte Abmessung zwischen etwa 100 % und 150 % der ersten, nicht verstellten Abmessung liegt.

11. Wärmeableitungsvorrichtung (16) für Telekommunikationsvorrichtungen, umfassend:
eine umschlossene Leitung (48), die sich zwischen einem offenen ersten Ende (50) und einem offenen zweiten Ende (52) erstreckt und eine Längsachse (64) definiert, wobei das offene erste Ende (50) dafür ausgelegt ist, mit einem Wärmeauslass (44) einer Aufnahmevorrichtung für Telekommunikationsausrüstung (12) gekoppelt zu werden, und das offene zweite Ende (52) dafür ausgelegt ist, mit einem Wärmeauslass (38) einer innerhalb der Aufnahmevorrichtung für Telekommunikationsausrüstung (12) angebrachten Telekommunikationsvorrichtung (14) gekoppelt zu werden, um einen Wärmeübertragungsweg zwischen den Wärmeauslässen (38, 44) der Telekommunikationsvorrichtung (14) und der Aufnahmevorrichtung für Telekommunikationsausrüstung (12) bereitzustellen, wobei eine äußere Abmessung (54) des offenen zweiten Endes (52) in der Größe verstellbar ist, um einer Vielzahl von Wärmeauslässen (38) unterschiedlicher Größe verschiedener Telekommunikationsvorrichtungen (14), welche innerhalb der Aufnahmevorrichtung für Telekommunikationsausrüstung (12) angebracht werden können, zu entsprechen, derart, dass ein Abschnitt der Leitung (48), der das offene zweite Ende (52) definiert, aus einem Material hergestellt ist, welches in einer radialen Richtung (66) bezüglich der Längsachse (64) dehnbar ist, und wobei die umschlossene Leitung (48) durch einen flexiblen Körper (56) definiert ist, um den Wärmeübertragungsweg zwischen dem Wärmeauslass (44) der Aufnahmevorrichtung für Telekommunikationsausrüstung (12) und einer Vielzahl unterschiedlicher Orte der Wärmeauslässe (38) verschiedener Telekommunikationsvorrichtungen (14), welche innerhalb der Aufnahmevorrichtung für Telekommunikationsausrüstung (12) angebracht werden können, aufrechtzuerhalten.

12. Wärmeableitungsvorrichtung (16) nach Anspruch 11, wobei der flexible Körper (56) rohrförmig ist.

13. Wärmeableitungsvorrichtung (16) nach Anspruch 12, wobei der rohrförmige Körper (56) im Wesentlichen zylindrisch ist.

14. Wärmeableitungsvorrichtung (16) nach Anspruch 12, wobei die äußere Abmessung (54) ein Durchmesser eines Kreises ist, der durch das offene zweite Ende (52) definiert ist.

15. Wärmeableitungsvorrichtung (16) nach Anspruch 11, wobei das offene zweite Ende (52) eine Befestigungsstruktur (68) aufweist, welche zum Koppeln mit verschiedenen Telekommunikationsvorrichtungen (14) konfigurierbar ist.

16. Wärmeableitungsvorrichtung (16) nach Anspruch 15, wobei die Befestigungsstruktur (68) einen Saugnapf (70) definiert, der dafür ausgelegt ist, eine Befestigung mit Vakuumdichtung an verschiedenen Telekommunikationsvorrichtungen (14) bereitzustellen.

17. Wärmeableitungsvorrichtung (16) nach Anspruch 16, wobei die Befestigungsstruktur (68) mehrere Saugnäpfe (70) definiert, die radial um das offene zweite Ende (52) herum angeordnet sind.

18. Wärmeableitungsvorrichtung (16) nach Anspruch 11, wobei die äußere Abmessung (54) des offenen zweiten Endes (52) in der Größe zwischen einer ersten, nicht verstellten Abmessung und einer zweiten, verstellten Abmessung verstellbar ist, wobei die zweite, verstellte Abmessung zwischen etwa 100 % und 200 % der ersten, nicht verstellten Abmessung liegt.

19. Wärmeableitungsvorrichtung (16) nach Anspruch 18, wobei die zweite, verstellte Abmessung zwischen etwa 100 % und 150 % der ersten, nicht verstellten Abmessung liegt.

20. Verfahren zum Ermöglichen von Wärmeableitung von verschiedenen Telekommunikationsvorrichtungen (14), die innerhalb einer Aufnahmevorrichtung für Telekommunikationsausrüstung (12) angebracht sind, wobei das Verfahren umfasst:
- Bereitstellen einer ersten Leitung (48), die sich zwischen einem offenen ersten Ende (50) und einem offenen zweiten Ende (52) erstreckt, wobei die erste Leitung (48) eine Längsachse (64) definiert;
- Koppeln des offenen ersten Endes (50) mit einem ersten Wärmeauslass (44) der Aufnahmevorrichtung für Telekommunikationsausrüstung (12); und
- Verstellen einer äußeren Abmessung (54) des offenen zweiten Endes (52) in der Größe, um einer Vielzahl von Wärmeauslässen (38) unterschiedlicher Größe verschiedener Telekommunikationsvorrichtungen (14) zu entsprechen, durch Dehnen oder Verengen eines Abschnitts der ersten Leitung (48) in einer radialen Richtung (66) bezüglich der Längsachse (64), wobei der Abschnitt der ersten Leitung (48), der das offene zweite Ende (52) definiert, aus einem Material hergestellt ist, welches in der radialen Richtung (66) bezüglich der Längsachse (64) dehnbar ist, und Koppeln des offenen zweiten Endes (52) mit einem Wärmeauslass (38) einer innerhalb der Aufnahmevorrichtung für Telekommunikationsausrüstung (12) angebrachten ersten Telekommunikationsvorrichtung (14), um einen Wärmeübertragungsweg zwischen dem Wärmeauslass (38) der ersten Telekommunikationsvorrichtung (14) und dem ersten Wärmeauslass (44) der Aufnahmevorrichtung für Telekommunikationsausrüstung (12) bereitzustellen.

21. Verfahren nach Anspruch 20, wobei die äußere Abmessung (54) des offenen zweiten Endes (52) in der Größe verstellbar ist, um einer Vielzahl von Wärmeauslässen (38) unterschiedlicher Größe verschiedener Telekommunikationsvorrichtungen (14), welche innerhalb der Aufnahmevorrichtung für Telekommunikationsausrüstung (12) angebracht werden können, zu entsprechen, und wobei die erste Leitung (48) durch einen flexiblen Körper (56) definiert ist, um den Wärmeübertragungsweg zwischen dem ersten Wärmeauslass (44) der Aufnahmevorrichtung für Telekommunikationsausrüstung (12) und einer Vielzahl unterschiedlicher Orte der Wärmeauslässe (38) verschiedener Telekommunikationsvorrichtungen (14), welche innerhalb der Aufnahmevorrichtung für Telekommunikationsausrüstung (12) angebracht werden können, aufrechtzuerhalten.

22. Verfahren nach Anspruch 20, welches ferner das Verstellen der äußeren Abmessung (54) des offenen zweiten Endes (52) in der Größe von einer ersten, nicht verstellten Abmessung zu einer zweiten, verstellten Abmessung umfasst, wobei die zweite, verstellte Abmessung zwischen etwa 100 % und 200 % der ersten, nicht verstellten Abmessung liegt.

23. Verfahren nach Anspruch 22, wobei die zweite, verstellte Abmessung zwischen etwa 100 % und 150 % der ersten, nicht verstellten Abmessung liegt.

24. Verfahren nach Anspruch 20, welches ferner das Bereitstellen einer zweiten Leitung (48), die der ersten Leitung (48) ähnlich ist, und das Koppeln eines offenen ersten Endes (50) der zweiten Leitung (48) mit einem zweiten Wärmeauslass (44) der Aufnahmevorrichtung für Telekommunikationsausrüstung (12) und das Verstellen einer äußeren Abmessung (54) eines offenen zweiten Endes (52) der zweiten Leitung (48) in der Größe und das Koppeln des offenen zweiten Endes (52) der zweiten Leitung (48) mit einem Wärmeauslass (38) einer innerhalb der Aufnahmevorrichtung für Telekommunikationsausrüstung (12) angebrachten zweiten Telekommunikationsvorrichtung (14), um einen Wärmeübertragungsweg zwischen dem Wärmeauslass (38) der zweiten Telekommunikationsvorrichtung (14) und dem zweiten Wärmeauslass (44) der Aufnahmevorrichtung für Telekommunikationsausrüstung (12) bereitzustellen, umfasst, wobei die zweite Telekommunikationsvorrichtung (14) einen Wärmeauslass (38) mit einer anderen Größe aufweist als die erste Telekommunikationsvorrichtung (14), welche innerhalb der Aufnahmevorrichtung für Telekommunikationsausrüstung (12) angebracht ist.

25. Verfahren nach Anspruch 24, wobei die zweite Telekommunikationsvorrichtung (14) einen anderen Ort des Wärmeauslasses (38) bezüglich des restlichen Teils der zweiten Telekommunikationsvorrichtung (14) definiert als die erste Telekommunikationsvorrichtung (14).

26. Verfahren nach Anspruch 20, welches ferner das Koppeln des offenen zweiten Endes (52) der ersten Leitung (48) mit dem Wärmeauslass (38) der ersten Telekommunikationsvorrichtung (14) durch Saugwirkung umfasst.

27. Verfahren nach Anspruch 20, welches ferner das Koppeln des offenen zweiten Endes (52) der ersten Leitung (48) mit dem Wärmeauslass (38) der ersten Telekommunikationsvorrichtung (14) durch Klebstoff umfasst.

28. Telekommunikationssystem (10), umfassend:
eine Aufnahmevorrichtung für Telekommunikationsausrüstung (12), die einen Wärmeauslass (44) aufweist;
eine Telekommunikationsvorrichtung (14), die innerhalb der Aufnahmevorrichtung für Telekommunikationsausrüstung (12) angebracht ist, wobei die Telekommunikationsvorrichtung (14) einen Wärmeauslass (38) aufweist; und
eine Wärmeableitungsvorrichtung (16), die eine Leitung (48) definiert, die sich zwischen einem offenen ersten Ende (50) und einem offenen zweiten Ende (52) erstreckt und eine Längsachse (64) definiert, wobei das offene erste Ende (50) mit dem Wärmeauslass (44) der Aufnahmevorrichtung für Telekommunikationsausrüstung (12) gekoppelt ist und das offene zweite Ende (52) mit dem Wärmeauslass (38) der Telekommunikationsvorrichtung (14) gekoppelt ist, um einen Wärmeübertragungsweg zwischen den Wärmeauslässen (38, 44) der Telekommunikationsvorrichtung (14) und der Aufnahmevorrichtung für Telekommunikationsausrüstung (12) bereitzustellen, wobei eine äußere Abmessung (54) des offenen zweiten Endes (52) in der Größe verstellbar ist, um einer Vielzahl von Wärmeauslässen (38) unterschiedlicher Größe verschiedener Telekommunikationsvorrichtungen (14), welche innerhalb der Aufnahmevorrichtung für Telekommunikationsausrüstung (12) angebracht werden können, zu entsprechen, derart, dass ein Abschnitt der Leitung (48), der das offene zweite Ende (52) definiert, aus einem Material hergestellt ist, welches in einer radialen Richtung (66) bezüglich der Längsachse (64) dehnbar ist, und die Leitung (48) durch einen flexiblen Körper (56) definiert ist.

29. Telekommunikationssystem (10) nach Anspruch 28, wobei das offene zweite Ende (52) mit dem Wärmeauslass (38) der Telekommunikationsvorrichtung (14) mit einem Saugnapf (70) gekoppelt ist.

30. Telekommunikationssystem (10) nach Anspruch 29, wobei die Wärmeableitungsvorrichtung (16) mehrere Saugnäpfe (70), die radial um das offene zweite Ende (52) herum angeordnet sind, zur Kopplung mit der Telekommunikationsvorrichtung (14) aufweist.

## Revendications

1. Dispositif de dissipation thermique (16) pour équipement de télécommunication, comprenant :
un conduit (48) défini par un corps souple (56), le conduit (48) s'étendant entre une première extrémité ouverte (50) conçue pour être accouplée à une sortie de chaleur (44) d'un accessoire de télécommunication (12), et une seconde extrémité ouverte (52) conçue pour être accouplée à une sortie de chaleur (38) d'un dispositif de télécommunication (14) monté à l'intérieur de l'accessoire de télécommunication (12) de manière à assurer une voie de transfert de chaleur entre les sorties de chaleur (38, 44), le premier conduit définissant un axe longitudinal (64), une dimension externe (54) de la première extrémité ouverte (50) et/ou de la seconde extrémité ouverte (52) pouvant être réglée en taille pour la faire correspondre à diverses sorties de chaleur de différentes tailles (38) de différents dispositifs de télécommunication (14) pouvant être monté à l'intérieur de l'accessoire de télécommunication (12) de sorte qu'une partie du conduit (48) définissant la première extrémité ouverte (50) et/ou la seconde extrémité ouverte (52) soit fabriquée dans un matériau extensible dans une direction radiale (66) par rapport à l'axe longitudinal (64).

2. Dispositif de dissipation thermique (16) selon la revendication 1, dans lequel le corps souple (56) est tubulaire.

3. Dispositif de dissipation thermique (16) selon la revendication 2, dans lequel le corps tubulaire (56) est généralement cylindrique.

4. Dispositif de dissipation thermique (16) selon la revendication 1, dans lequel la dimension externe (54) est un diamètre d'un cercle défini par la première extrémité ouverte (50) et/ou la seconde extrémité ouverte (52).

5. Dispositif de dissipation thermique (16) selon la revendication 1, dans lequel la dimension externe (54) de la seule seconde extrémité (52) est réglable en taille.

6. Dispositif de dissipation thermique (16) selon la revendication 1, dans lequel la première extrémité ouverte (50) et/ou la seconde extrémité ouverte (52) incluent une structure de fixation (68) permettant d'accoupler la première extrémité ouverte (50) et/ou la seconde extrémité ouverte (52) à un dispositif de télécommunication (14).

7. Dispositif de dissipation thermique (16) selon la revendication 1, dans lequel la structure de fixation (68) définit une ventouse (70) conçue pour assurer un joint de vide avec le dispositif de télécommunication (14).

8. Dispositif de dissipation thermique (16) selon la revendication 6, dans lequel la structure de fixation (68) définit une pluralité de ventouses (70) disposées radialement autour de la première extrémité ouverte (50) et/ou de la seconde extrémité ouverte (52).

9. Dispositif de dissipation thermique (16) selon la revendication 1, dans lequel la dimension externe (54) de la première extrémité ouverte (50) et/ou de la seconde extrémité ouverte (52) est réglable en taille entre une première dimension non réglée et une seconde dimension réglée, la seconde dimension réglée étant comprise entre environ 100 % et 200 % de la première dimension non réglée.

10. Dispositif de dissipation thermique (16) selon la revendication 9, dans lequel la seconde dimension réglée est comprise entre environ 100 % et 150 % de la première dimension non réglée.

11. Dispositif de dissipation thermique (16) pour équipement de télécommunication, comprenant :
un conduit fermé (48) s'étendant entre une première extrémité ouverte (50) et une seconde extrémité ouverte (52) et définissant un axe longitudinal (64), la première extrémité ouverte (50) étant conçue pour être accouplée à une sortie de chaleur (44) d'un accessoire de télécommunication (12), et la seconde extrémité ouverte (52) étant conçue pour être accouplée à une sortie de chaleur (38) d'un dispositif de télécommunication (14) monté à l'intérieur de l'accessoire de télécommunication (12) de manière à assurer une voie de transfert de chaleur entre les sorties de chaleur (38, 44) du dispositif de télécommunication (14) et de l'accessoire de télécommunication (12), une dimension externe (54) de la seconde extrémité ouverte (52) pouvant être réglée en taille pour la faire correspondre à diverses sorties de chaleur de différentes tailles (38) de différents dispositifs de télécommunication (14) pouvant être monté à l'intérieur de l'accessoire de télécommunication (12) de sorte qu'une partie du conduit (48) définissant la seconde extrémité ouverte (52) soit fabriquée dans un matériau extensible dans une direction radiale (66) par rapport à l'axe longitudinal (64), et le conduit fermé (48) étant défini par un corps souple (56) permettant de maintenir la voie de transfert de chaleur entre la sortie de chaleur (44) de l'accessoire de télécommunication (12) et divers emplacements différents de sortie de chaleur (38) de différents dispositifs de télécommunication (14) pouvant être montés à l'intérieur de l'accessoire de télécommunication (12).

12. Dispositif de dissipation thermique (16) selon la revendication 11, dans lequel le corps souple (56) est tubulaire.

13. Dispositif de dissipation thermique (16) selon la revendication 12, dans lequel le corps tubulaire (56) est généralement cylindrique.

14. Dispositif de dissipation thermique (16) selon la revendication 12, dans lequel la dimension externe (54) est un diamètre d'un cercle défini par la seconde extrémité ouverte (52).

15. Dispositif de dissipation thermique (16) selon la revendication 11, dans lequel la seconde extrémité ouverte (52) comprend une structure de fixation (68) pouvant être configurée pour s'accoupler à différents dispositifs de télécommunication (14).

16. Dispositif de dissipation thermique (16) selon la revendication 15, dans lequel la structure de fixation (68) définit une ventouse (70) conçue pour assurer une fixation par joint de vide avec différents dispositifs de télécommunication (14).

17. Dispositif de dissipation thermique (16) selon la revendication 16, dans lequel la structure de fixation (68) définit une pluralité de ventouses (70) disposées radialement autour de la seconde extrémité ouverte (52).

18. Dispositif de dissipation thermique (16) selon la revendication 11, dans lequel la dimension externe (54) de la seconde extrémité ouverte (52) est réglable en taille entre une première dimension non réglée et une seconde dimension réglée, la seconde dimension réglée étant comprise entre environ 100 % et 200 % de la première dimension non réglée.

19. Dispositif de dissipation thermique (16) selon la revendication 18, dans lequel la seconde dimension réglée est comprise entre environ 100 % et 150 % de la première dimension non réglée.

20. Procédé permettant la dissipation thermique de différents dispositifs de télécommunication (14) montés à l'intérieur d'un accessoire de télécommunication (12), le procédé consistant à :
fournir un premier conduit (48) s'étendant entre une première extrémité ouverte (50) et une seconde extrémité ouverte (52), le premier conduit (48) définissant un axe longitudinal (64) ;
accoupler la première extrémité ouverte (50) à une première sortie de chaleur (44) de l'accessoire de télécommunication (12) ; et
régler une dimension externe (54) de la seconde extrémité ouverte (52) en taille pour la faire correspondre à diverses sorties de chaleur de différentes tailles (38) de différents dispositifs de télécommunication (14) en allongeant ou en contractant une partie du premier conduit (48) dans une direction radiale (66) par rapport à l'axe longitudinal (64), la partie du premier conduit (48) définissant la seconde extrémité ouverte (52) étant fabriqué dans un matériau extensible dans la direction radiale (66) par rapport à l'axe longitudinal (64), et accoupler la seconde extrémité ouverte (52) à une sortie de chaleur (38) d'un premier dispositif de télécommunication (14) monté à l'intérieur de l'accessoire de télécommunication (12) de manière à assurer une voie de transfert de chaleur entre la sortie de chaleur (38) du premier dispositif de télécommunication (14) et la première sortie de chaleur (44) de l'accessoire de télécommunication (12).

21. Procédé selon la revendication 20, dans lequel la dimension externe (54) de la seconde extrémité ouverte (52) est réglable en taille pour la faire correspondre à diverses sorties de chaleur de différentes tailles (38) de différents dispositifs de télécommunication (14) pouvant être montés à l'intérieur de l'accessoire de télécommunication (12), et dans lequel le premier conduit (48) est défini par un corps souple (56) permettant de maintenir la voie de transfert de chaleur entre la première sortie de chaleur (44) de l'accessoire de télécommunication (12) et divers emplacements différents de sortie de chaleur (38) de différents dispositifs de télécommunication (14) pouvant être montés à l'intérieur de l'accessoire de télécommunication (12).

22. Procédé selon la revendication 20, consistant en outre à régler la dimension externe (54) de la seconde extrémité ouverte (52) en taille entre une première dimension non réglée et une seconde dimension réglée, la seconde dimension réglée étant comprise entre environ 100 % et 200 % de la première dimension non réglée.

23. Procédé selon la revendication 22, dans lequel la seconde dimension réglée est comprise entre environ 100 % et 150 % de la première dimension non réglée.

24. Procédé selon la revendication 20, consistant en outre à fournir un second conduit (48) similaire au premier conduit (48) et accoupler une première extrémité ouverte (50) du second conduit (48) à une seconde sortie de chaleur (44) de l'accessoire de télécommunication (12), et régler une dimension externe (54) d'une seconde extrémité ouverte (52) du second conduit (48) en taille et accoupler la seconde extrémité ouverte (52) du second conduit (48) à une sortie de chaleur (38) d'un second dispositif de télécommunication (14) monté à l'intérieur de l'accessoire de télécommunication (12) de manière à assurer une voie de transfert de chaleur entre la sortie de chaleur (38) du second dispositif de télécommunication (14) et la seconde sortie de chaleur (44) de l'accessoire de télécommunication (12), le second dispositif de télécommunication (14) comprenant une sortie de chaleur (38) de taille différente de celle du premier dispositif de télécommunication (14) monté à l'intérieur de l'accessoire de télécommunication (12).

25. Procédé selon la revendication 24, dans lequel le second dispositif de télécommunication (14) définit un emplacement de sortie de chaleur (38) différent, par rapport au reste du second dispositif de télécommunication (14), du premier dispositif de télécommunication (14).

26. Procédé selon la revendication 20, consistant en outre à accoupler la seconde extrémité ouverte (52) du premier conduit (48) à la sortie de chaleur (38) du premier dispositif de télécommunication (14) par aspiration.

27. Procédé selon la revendication 20, consistant en outre à accoupler la seconde extrémité ouverte (52) du premier conduit (48) à la sortie de chaleur (38) du premier dispositif de télécommunication (14) par l'intermédiaire d'un adhésif.

28. Système de télécommunication (10), comprenant :
un accessoire de télécommunication (12) comprenant une sortie de chaleur (44) ;
un dispositif de télécommunication (14) monté à l'intérieur de l'accessoire de télécommunication (12), le dispositif de télécommunication (14) comprenant une sortie de chaleur (38) ; et
un dispositif de dissipation thermique (16) définissant un conduit (48) s'étendant entre une première extrémité ouverte (50) et une seconde extrémité ouverte (52) et définissant un axe longitudinal (64), la première extrémité ouverte (50) étant accouplée à la sortie de chaleur (44) de l'accessoire de télécommunication (12), et la seconde extrémité ouverte (52) étant accouplée à la sortie de chaleur (38) du dispositif de télécommunication (14) de manière à assurer une voie de transfert de chaleur entre les sorties de chaleur (38, 44) du dispositif de télécommunication (14) et de l'accessoire de télécommunication (12), une dimension externe (54) de la seconde extrémité ouverte (52) pouvant être réglée en taille pour la faire correspondre à diverses sorties de chaleur de différentes tailles (38) de différents dispositifs de télécommunication (14) pouvant être monté à l'intérieur de l'accessoire de télécommunication (12) de sorte qu'une partie du conduit (48) définissant la seconde extrémité ouverte (52) soit fabriquée dans un matériau extensible dans une direction radiale (66) par rapport à l'axe longitudinal (64), et le conduit (48) étant défini par un corps souple (56).

29. Système de télécommunication (10) selon la revendication 28, dans lequel la seconde extrémité ouverte (52) est accouplée à la sortie de chaleur (38) du dispositif de télécommunication (14) au moyen d'une ventouse (70).

30. Système de télécommunication (10) selon la revendication 29, dans lequel le dispositif de dissipation thermique (16) comprend une pluralité de ventouses (70) disposées radialement autour de la seconde extrémité ouverte (52) permettant son accouplement au dispositif de télécommunication (14).
